# EUROPEAN PATENT SPECIFICATION

(11) **EP 3 829 285 B1**
(45) Date of publication and mention of the grant of the patent: **29.10.2025**
(21) Application number: 18927474.9
(22) Date of filing: 24.07.2018
(51) Int. Cl.: H05K 13/04, H05K 13/00, H05K 13/08

(54) **WORK ASSISTANCE DEVICE AND SUBSTRATE WORK MACHINE**
ARBEITSUNTERSTÜTZUNGSVORRICHTUNG UND SUBSTRATBEARBEITUNGSMASCHINE
DISPOSITIF D'AIDE AU TRAVAIL ET MACHINE DE TRAVAIL DE SUBSTRAT

(43) Date of publication of application: 02.06.2021
(73) Proprietor: Fuji Corporation, Chiryu-shi, Aichi 472-8686 (JP)
(72) Inventor: OHASHI, Teruyuki, Chiryu-shi, Aichi 472-8686 (JP)
(74) Representative: Grünecker Patent- und Rechtsanwälte PartG mbB
(86) International application number: PCT/JP2018/027633
(87) International publication number: WO 2020/021620

(56) References cited:
- JP-A- 2004 119 535
- JP-A- 2007 109 778
- JP-A- 2012 104 803
- JP-A- 2014 029 962
- JP-A- H08 222 898

## Description

### Technical Field

The present invention relates to a work assistance device and a substrate work machine.

### Background Art

Work assistance devices are applied to substrate work machines used in the production of substrate products. Substrate work machines perform predetermined operations on substrates in multiple work positions arranged in advance. Patent Literature 1 discloses a component mounting machine as a substrate work machine. The component mounting machine mounts components to each of a number of mounting positions designated on a substrate through a control program.

### Patent Literature

Patent Literature 1: Japanese Patent Laid-Open No. 2017-183586

JP 2007 109778 A discloses a method for mounting an electronic component capable of executing mounting operation for a multiply chamfered substrate in which a plurality of different kinds of unit substrates are formed (summary). A mounting data storage unit is disclosed including mounting data necessary for mounting the electronic component on each unit board of the parent board, that is, unit board position data indicating the position of the unit board on the multi-sided board, and mounting of the electronic parts on the unit board.

JP 2014 029962 A discloses a mounting machine capable of reducing the use amount of a memory mounted on the mounting machine, when electric components are mounted on a multiple substrate. The mounting machine includes: a memory portion for storing mounting coordinate data, reference position data, and transition order data; and a control unit for mounting unit substrates by using develop coordinate data.

JP 2004 119535 A discloses a method to accurately arrange and package all electronic components on a substrate by small information quantity in an electronic component packaging method for arranging a plurality of electronic components on the substrate at regular intervals.

JP 2012 104803 A discloses a method for optimizing component mounting utilizing variable pitch heads, and a component mounting device utilizing the method. In the method for optimizing component mounting utilizing variable pitches, in order to adsorb components by mounting heads having the variable pitches capable of adsorbing the components from the array of a plurality of component feed parts storing the components.

JP H08 222 898 A discloses a method to decide the mounting order of parts in a short calculating time so that the mounting time of the parts can be made sufficiently shorter.

It is the object of the present invention to provide an improved work assistance device for a substrate work machine.

This object is solved by the subject matter of the independent claims.

Embodiments are defined in the dependent claims.

### Technical Problem

The file size of the control program used by the substrate work machine for various types of operations increases in accordance with the number of work positions on the substrate. Therefore, the time required by the control program for various processes including browsing and communicating to designate a large number of work positions increases, raising the possibility of affecting production efficiency.

It is an object of the present specification to provide a work assistance device configured to generate work data to more efficiently designate multiple work positions arranged in advance on a substrate, and a substrate work machine configured to execute predetermined operations by developing the above-mentioned work data.

### Solution to Problem

The present specification discloses a work assistance device, applied to a substrate work machine configured to perform a predetermined operation at multiple work positions arranged in advance on a substrate, comprising: a rule detecting section configured to detect a reference position and an arrangement rule for multiple work positions based on the positional relationship of the multiple work positions; and a data generation section configured to generate work data for designating the multiple work positions using the reference position of the substrate and the arrangement rule detected by the rule detecting section.

The present specification discloses a substrate work machine comprising: a moving head provided in a manner which allows movement in a horizontal direction inside the substrate work machine; a work position recognition section configured to recognize the multiple work positions by developing work data designating multiple work positions arranged in advance on a substrate using a reference position of the substrate and a predetermined arrangement rule; and a work control section configured to perform the predetermined work by sequentially moving the moving head to each of the multiple recognized work positions.

### Advantageous Effect of the Invention

With a work assistance device having such a configuration, it is possible to generate work data for designating multiple work positions using a reference position and an arrangement rule, provided these work positions have a predetermined arrangement rule, even if there is a large number of work positions arranged in advance on a substrate. As a result, the file size of the work data is reduced compared with a control program in which all the work positions are individually designated. Therefore, the time required for various processes on the work data including browsing and communicating is reduced. As a result, the production efficiency is improved.

With a substrate work machine having such a configuration, it is possible to develop work data in which the file size is reduced compared with a control program for individually designating all work positions and perform predetermined operations at multiple work positions. As a result, the time required for various processes on the work data including browsing and communicating is reduced. As a result, the production efficiency is improved. Further, increases in equipment costs can be suppressed as device configurations for handling large file sizes becomes unnecessary.

### Brief Description of Drawings

[Fig. 1] A schematic diagram showing a production system including a work assistance device and a component mounting machine of the embodiment.
[Fig. 2] A schematic diagram showing a configuration of the component mounting machine in the production line of Fig. 1.
[Fig. 3A] A plan view showing a state in which components are mounted to multiple mounting positions arranged in a matrix on a substrate.
[Fig. 3B] A plan view showing a state in which components are mounted to multiple mounting positions on a substrate arranged by multiple arrangement rules.
[Fig. 3C] A plan view showing a state in which components comprising multiple component types are mounted at multiple mounting positions arranged on a substrate.
[Fig. 4] A diagram showing various data including work data.
[Fig. 5] A flowchart showing a work assistance process.
[Fig. 6] A flowchart showing a rule acquisition process.

### Description of Embodiments

### 1. Overview of production system 1

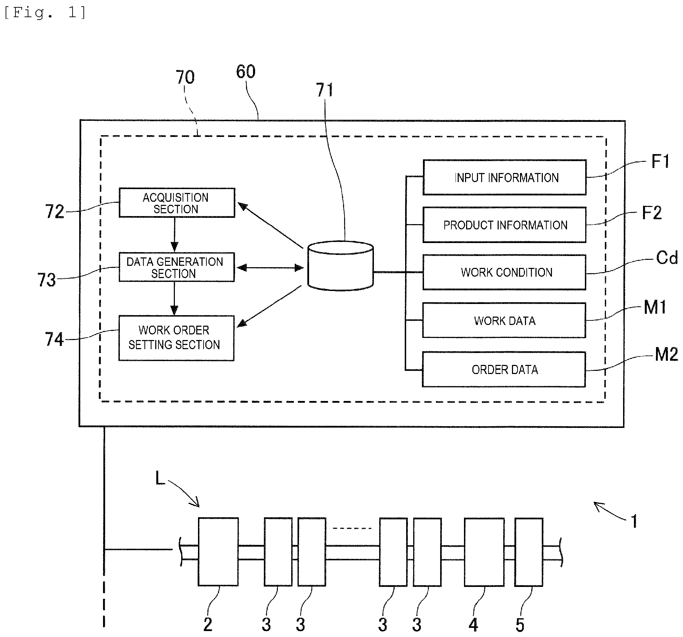

Work assistance device is applied to, for example, a substrate work machine constituting production system 1 of a substrate product. **In** the present embodiment, a mode is demonstrated in which a work assistance device has the mounting process by component mounting machine 3, which is a substrate work machine, as a target. As shown in Fig. 1, production system 1 is configured by one or more production lines L and host computer 60 that collectively manages production lines L.

### 2. Configuration of production line L

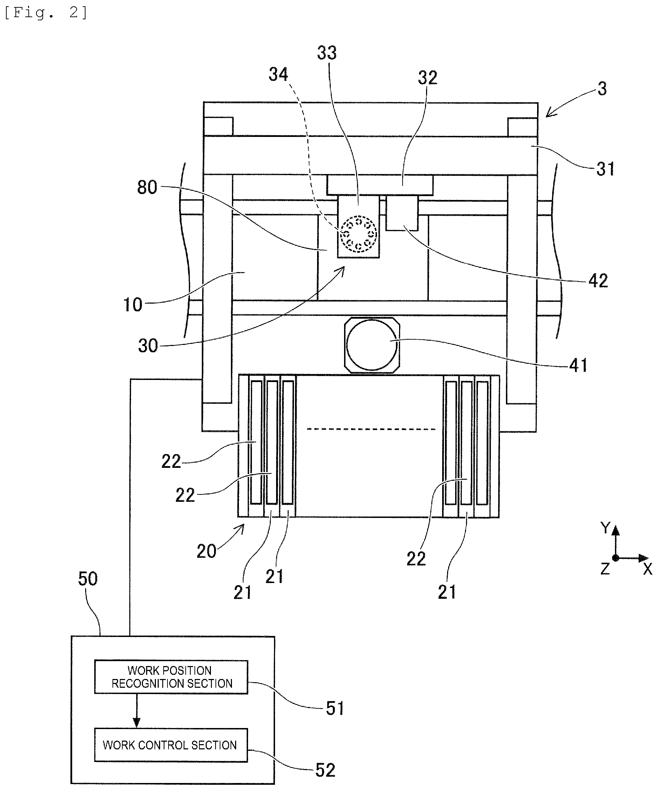

Each production line L is configured by placing multiple substrate work machines in the conveyance direction of substrate 80 (see Fig.2). Each of the multiple substrate work machines is connected in communication with host computer 60. Production line L is provided with multiple substrate work machines including printing machine 2, multiple component mounting machines 3, reflow furnace 4, and inspection machine 5.

Printing machine 2 prints paste-like solder to component mounting positions on a conveyed-in substrate 80. Each of the multiple component mounting machine 3 mounts components to substrate 80 conveyed from the upstream side of production line L. The configuration of component mounting machine 3 will be described later. Reflow furnace 4 heats substrate 80 conveyed from the upstream side of production line L and performs soldering by melting solder on substrate 80. Inspection machine 5 inspects whether the appearance or function of the substrate product produced by production line L is normal.

The configuration of production line L may be appropriately added to or changed in accordance with, for example, the type of substrate product to be produced. Specifically, in production line L, a buffer device for temporarily holding substrate 80 to be conveyed, a substrate supply device, a substrate reversing device, various inspection devices, a shield mounting device, an adhesive coating device, a chip transfer device, an ultraviolet irradiation device, and the like can be installed as appropriate.

### 3. Configuration of component mounting machine 3

Component mounting machine 3 executes a mounting process of mounting components on substrate 80. Component mounting machine 3, as shown in Fig. 2, substrate conveyance device 10, component supply device 20, component transfer device 30, part camera 41, substrate camera 42, and control device 50. In the following description, it is assumed that the horizontal first direction of component mounting machine 3 is the X-direction, the horizontal second direction intersecting the X-direction, the front-rear direction of component mounting machine 3 is the Y-direction, and the vertical direction orthogonal to the X-direction and the Y-direction (i.e., the front-rear direction in Fig. 2) is the Z-direction.

Substrate conveyance device 10 is constituted by a belt conveyor, a positioning device, and the like. In addition to sequentially conveying substrate 80 in the conveyance direction, substrate conveyance device 10 positions substrate 80 at a predetermined position in the machine. After the component mounting process by component mounting machine 3 is completed, substrate conveyance device 10 conveys substrate 80 out of component mounting machine 3.

Component supply device 20 supplies components to be mounted on substrate 80. Component supply device 20 has multiple slots 21 arranged side by side in the X-direction and feeders 22 set in each of the multiple slots 21. Feeder 22 feeds and moves a carrier tape in which a large number of components are accommodated. With this, feeder 22 supplies components in a manner which allows the components to be picked up at a supply position provided at the distal end side of feeder 22.

Component transfer device 30 transfers the components supplied by component supply device 20 to a predetermined mounting position on substrate 80 conveyed into the machine by substrate conveyance device 10. Head driving device 31 of component transfer device 30 moves moving table 32 in the horizontal direction (X-direction and Y-direction) by a linear motion mechanism. Moving table 32, mounting head 33 is fixed by a clamp member (not shown) in a manner which allows exchanging. Mounting head 33 supports multiple suction nozzles 34 in a manner which allows each suction nozzle 34 to be rotated and lifted/lowered. Suction nozzle 34 picks up components supplied by feeder 22 by supplied negative pressure air.

Part camera 41 and substrate camera 42 are digital imaging devices having an imaging device such as a CMOS. Part camera 41 and substrate camera 42 perform imaging based on control signals and send image data acquired by the imaging. Component camera 41 is fixed to a base so that the optical axis is directed upward in the Z-direction. Component camera 41 is configured to image components held by suction nozzle 34 of mounting head 33 from below. Substrate camera 42 is fixed to moving table 32 so that the optical axis is directed downward to moving table 32 in the Z-direction and moves integrally with mounting head 33 with the movement of moving table 32. Substrate camera 42 is configured to image substrate 80 from above.

Control device 50 mainly includes a CPU, various types of memory, and a control circuit. Control device 50 controls the mounting process of mounting components on substrate 80. The above mounting process includes a process of repeating multiple times a pick-and-place cycle (hereinafter, referred to as "PP cycle"), for picking up components supplied by component supply device 20 and mounting the components to mounting positions on substrate 80.

In the mounting process, control device 50 controls the operation of component transfer device 30 based on the results of information and image processing outputted from various sensors, control programs for designating mounting positions on substrate 80, and the like. With this configuration, the positions and angles of multiple suction nozzles 34 supported by mounting head 33 are controlled. In addition to the above-mentioned control programs, control device 50 is configured to control the mounting process on based on work data generated by work assistance device 70, which will be described later, and the like. A detailed configuration of control device 50 of component mounting machine 3 will be described later.

### 4. Overview of host computer 60 and configuration of work assistance device 70

Host computer 60 monitors the operational state of production line L and controls substrate work machines such as component mounting machine 3. Host computer 60 functions as work assistance device 70 of a substrate work machine by way of constituent devices and installed software. In the present embodiment, work assistance device 70 generates work data to more efficiently designate multiple mounting positions, thereby assisting the mounting process of component mounting machine 3.

Here, the control program used for the mounting process of component mounting machine 3 designates the mounting positions, mounting angles, component types to be mounted on substrate 80, and the like. Therefore, the control program increases file size depending on the number of mounting positions on substrate 80. Further, it is possible that component mounting machine 3 will execute a mounting process for mounting components at a high density on a large substrate. In such a case, if the file size of the control program increases as the number of mounting positions increases, there is a concern that the time required for various processes of the control program will increase.

The various processes of the control program include, for example, a browsing process for checking the content of the control program, an optimization process for optimizing the mounting order, and a communication process transmitted from host computer 60 to component mounting machine 3. Further, when the file size of the control program increases, a device configuration having a storage device for handling the file size is required in component mounting machine 3. Therefore, there is a concern that installation costs will increase due to the mounting process that accompanies a large amount of mounting.

Therefore, work assistance device 70 of the present embodiment employs a configuration to reduce the file size by generating work data to more efficiently designate multiple mounting positions arranged in advance on substrate 80. Specifically, as shown in Fig. 1, work assistance device 70 includes storage section 71, acquisition section 72, data generation section 73, and work order setting section 74.

Storage section 71 is configured by an optical drive device such as a hard disk device, flash memory, or the like. Storage section 71 stores various data such as a control program used for controlling the substrate work machine. Storage section 71 stores work condition Cd, work data M1, and order data M2, which will be described later.

Acquisition section 72 acquires a reference position and arrangement rules for the multiple mounting positions arranged in advance on substrate 80. Here, the multiple mounting positions are, for example, component arrangement positions determined by the design of the substrate product. The "reference position" of the multiple mounting positions is a position relative to the origin in the coordinate system of the substrate positioned in the machine, and is a position that becomes a mounting process reference defined with respect to the substrate and is not affected by errors in positioning the substrate.

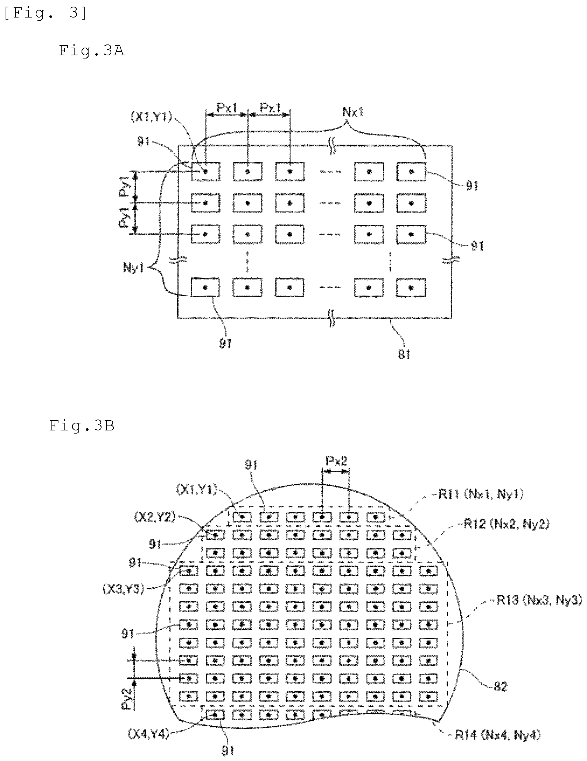

Further, in the mounting process, depending on the function or the like required for the substrate product, for example, the same kind of components, such as LED elements, may be mounted in a large quantity on substrate 80. In such a case, the multiple mounting positions may have a uniform arrangement rule. Specifically, as shown in Fig. 3A, first components 91 of the same component type may be arranged in a matrix on first substrate 81 having a rectangular shape. In this case, the mounting positions of the multiple first components 91 are designated by a predetermined reference position (X1, Y1), an arrangement rule indicating the spacing in the XY-directions (Px1, Py1), and the quantity (Nx1, Ny1).

Further, as shown in Fig. 3B, first components 91 of the same component type may be arranged so as to fit inside a circular region on second substrate 82 having a circular shape. In this case, the mounting positions of the multiple first components 91 are designated by multiple reference positions ((X1, Y1), (X2, Y2),..) which are different from each other, and multiple arrangement rules having the same spacing (Px1, Py1) in the XY-directions and different quantities ((Nx1, Ny1), (Nx2, Ny2),..) in the XY-directions.

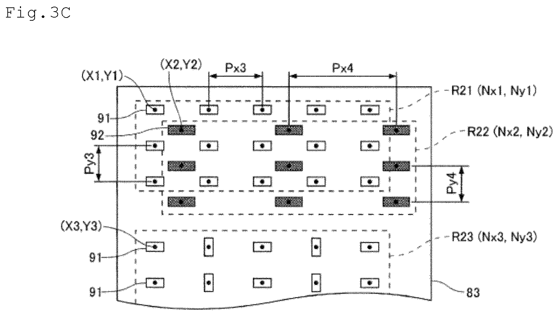

In addition, as shown in Fig. 3C, first components 91 and second components 92 having different component types may be arranged in matrices in mutually overlapping regions on third substrate 83 having a rectangular shape. In this case, the mounting positions of the multiple first components 91 and the mounting positions of the multiple second components 92 have different reference positions and arrangement rules from each other, or only the reference positions are different from each other but are designated by the same arrangement rule.

The following first and second modes can be applied to a rule acquisition process in which acquisition section 72 acquires a reference position and an arrangement rule as described above. In the first mode of the rule acquisition process, acquisition section 72 acquires a reference position of multiple mounting positions and an arrangement rule from input information F1 inputted by an operator. With the configuration of the first mode, for example, when a designer or the like of a substrate product designates multiple mounting positions based on a reference position and an arrangement rule, the designation information can be input information F1. As a result, it becomes possible to more accurately designate multiple mounting positions.

Further, in the second mode of the rule acquisition process, acquisition section 72 executes a search process to search for the arrangement rule of multiple work positions and acquires the arrangement rule based on the result of the search process. The search process by acquisition section 72 is executed on design product information F2 in which mounting positions, mounting angles, and component types of all components to be mounted in the mounting process are designated. Details of the second mode of the rule acquisition process will be described later.

Here, in the rule acquisition process as described above, for example, as shown in the Fig. 3B, when the arrangement rules of the multiple mounting positions differ for each of the multiple regions (R11, R12,..) that do not overlap each other for the same component type on second substrate 82, acquisition section 72 acquires the arrangement rules for each of the multiple regions (R11, R12,..). On the other hand, for example, as shown in the Fig. 3C, for the different component types, acquisition section 72 acquires the arrangement rules for each of the multiple regions (R21, R22,..) regardless of whether the regions (R21, R22,..) overlap each other on third substrate 83.

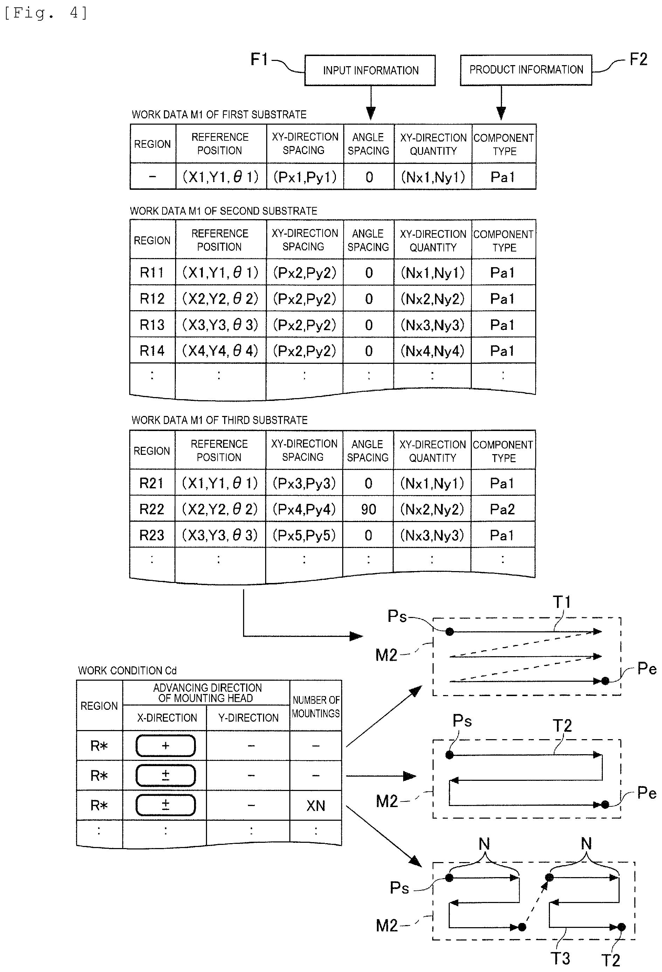

Data generation section 73 generates work data M1 for designating multiple mounting positions using the reference positions and the arrangement rules acquired by acquisition section 72 (refer to Fig. 4). When acquisition section 72 acquires multiple arrangement rules, data generation section 73 generates work data M1 using the reference positions and the multiple arrangement rules determined for each of the multiple regions R11, R12. Work data M1 designates multiple mounting positions in the coordinate system of substrate 80 based on one or more reference positions and an arrangement rule. In other words, work data M1 does not determine in what order the components are mounted at the multiple mounting positions.

Work order setting section 74 sets the mounting order (corresponding to the "work order") in which component mounting machine 3 performs mounting at multiple mounting positions designated by work data M1 based on work condition Cd set in advance. The above-described "work condition Cd" includes at least one of a moving direction of mounting head 33, a moving direction in which mounting head 33 takes precedence, and the number of mountings in the same moving direction as that of mounting head 33 (corresponding to the "number of operations"). The moving direction of mounting head 33 described above is set, as shown in Fig. 4, for example, in the "+" X-direction and the "-" Y-direction.

Thus, the mounting position of the most "-" side and the mounting position of the most "+" side of the Y-direction becomes starting position Ps, the mounting position of the most "+" side of the X-direction and the most "-" side of the Y-direction becomes end position Pe. Then, when the preferred moving direction of mounting head 33 is set to the "+" X-direction (indicated by the thick frame in Fig. 4), the mounting order is set along first trace T1 in Fig. 4. Further, when the moving direction of mounting head 33 is set to the "±" X-direction, along second trace T2 in Fig. 4, the mounting order is set along second trace T2 in Fig. 4 which returns and retraces the path with respect to the X-direction.

Incidentally, the maximum number of components that can be picked up in one PP cycle in the mounting process is equal to the number of suction nozzles 34 supported by mounting head 33. Therefore, in consideration of the maximum number of suction nozzles 34 that can be picked up corresponding to the number of mountings in the moving direction of mounting head 33, for example, setting the number of mountings in the X-direction in one PP cycle may enable an efficient mounting process to be performed.

Therefore, as described above, the number of mountings in the moving direction of mounting head 33 can be set in work condition Cd. Thus, for example, when XN, which refers to N mountings in the X-direction, is set as a mounting condition, N is made as the limit for the number of mountings in the X-direction in one PP cycle, and the mounting order is set so as to follow third trace T3 in Fig.4.

In the present embodiment, work order setting section 74 generates order data M2 indicating the set mounting order. Various modes may be adopted for order data M2 provided the order in which the components are mounted to multiple mounting positions designated by work data M1 are indicated. Order data M2 may indicate, for example, the mounting order determined by work condition Cd with items such as the start position, the end position, the advancing direction, and the returning position. Further, order data M2 may simply indicate the mounting order with the same setting items as work condition Cd.

Further, work order setting section 74 performs a replacement process to the mounting order, set based on work condition Cd and work data M1, based on at least one of the moving distance of mounting head 33 and the time required for the predetermined work. Here, depending on the machine configuration in the mounting process (e.g., the set position of feeder 22 with respect to slot 21 and the type of suction nozzle 34 used) and the various conditions for preventing interference, the mounting order set based on work condition Cd is not necessarily the optimal order.

Therefore, work order setting section 74 replaces the mounting order set based on work condition Cd based on various conditions. Specifically, work order setting section 74 executes the replacement process to shorten the moving distance of mounting head 33 in the mounting process or to shorten the time required for the mounting process. As a result, work order setting section 74 substantially optimizes the mounting process. Work order setting section 74, in the present embodiment, edits order data M2 based on the result of the replacement process.

### 5. Detailed configuration of control device 50 of component mounting machine 3

Component mounting machine 3 of the present embodiment employs a configuration capable of expanding the work data generated as described above and executing the mounting process. Specifically, control device 50 of component mounting machine 3, as shown in Fig. 2, includes mounting position recognition section 51 and mounting control section 52. Mounting position recognition section 51 develops work data M1 and recognizes multiple mounting positions. Specifically, when the origin of the coordinate system of substrate 80 is detected after substrate 80 is positioned in the machine, the position on substrate 80 at which the component is to be mounted in the mounting process is recognized.

Mounting control section 52 performs the mounting process by sequentially moving mounting head 33 to each of the multiple mounting positions recognized by mounting position recognition section 51. In the present embodiment, mounting control section 52 sets the order of mounting the components to the multiple mounting positions based on order data M2 generated by work order setting section 74. Mounting control section 52 then executes the mounting process by appropriately repeating the PP cycle.

### 6. Work assistance process of work assistance device 70

The work assistance process of work assistance device 70 having the above-described configuration will be described with reference to Figs. 4 to 6. Work assistance device 70 assists the mounting process by component mounting machine 3, which is a substrate work machine. Further, the type and mounting position of the component to be mounted on substrate 80 by the mounting process described above is set in advance by the design of the substrate product.

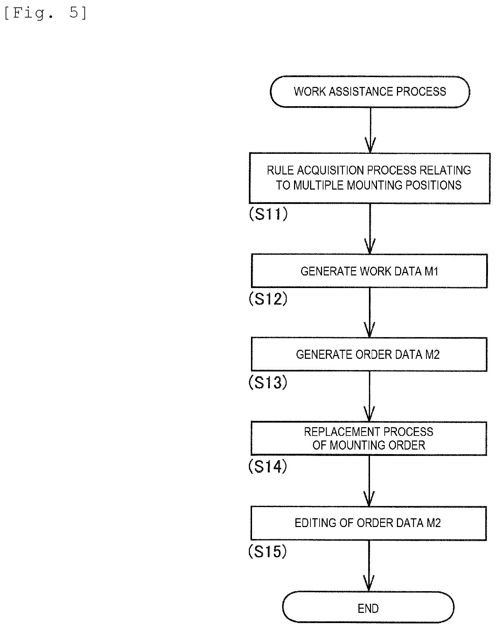

In the work assistance process, as shown in Fig. 5, acquisition section 72 first executes the rule acquisition process relating to the multiple mounting positions (S11). When the input of a reference position and an arrangement rule by an operator is received, acquisition section 72 acquires the reference position and the arrangement rule of multiple mounting positions from input information F1 inputted by the operator. On the other hand, when input information F1 is not inputted, acquisition section 72 executes a search process for the arrangement rule and acquires the arrangement rule based on the result of the search process.

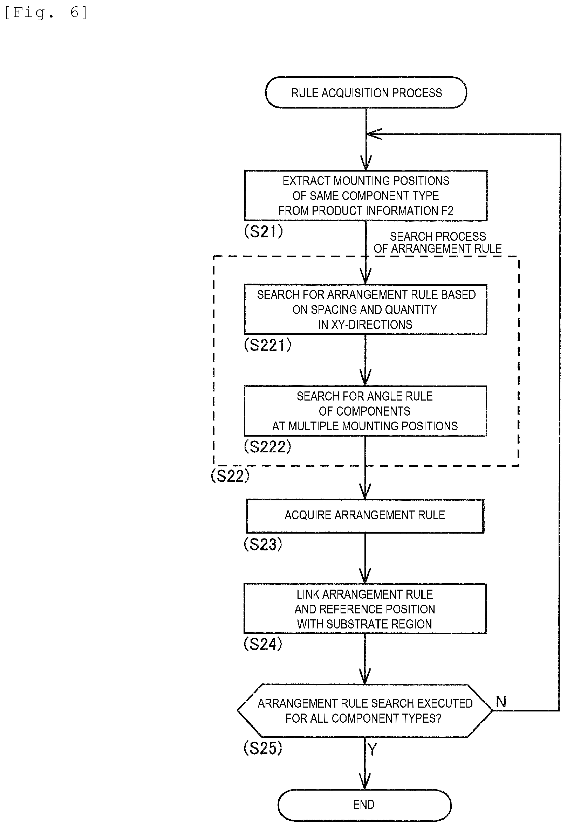

In detail, as shown in Fig. 6, acquisition section 72 first extracts the mounting positions of the same component type from product information F2 (S21). Next, acquisition section 72 performs a search process for an arrangement rule on the multiple mounting positions extracted in S21 (S22). In the present embodiment, in the search process (S22), acquisition section 72 searches for an arrangement rule based on the spacing and quantity of multiple mounting positions in both the X-direction and the Y-direction (S221).

More specifically, acquisition section 72 calculates, for example, the spacing between mounting positions adjacent to each other in the X-direction. Acquisition section 72 assumes that the multiple mounting positions are arranged at a regular interval when the spacings differ from each other by a preset tolerance value or less. Acquisition section 72 counts the number of mounting positions adjacent to each other in the X-direction and spaced apart at regular intervals. Acquisition section 72 similarly calculates the spacing and counts the quantity in the Y-direction.

Next, in the search process (S22), acquisition section 72 searches for an angle rule for components at the multiple mounting positions arranged at regular intervals (S222). Specifically, acquisition section 72 calculates the angular difference of the component to be mounted at the mounting position adjacent to the X-direction, for example. When the angular difference is equal to or less than a preset tolerance value, acquisition section 72 performs mounting while systematically changing the angle of the component at the multiple mounting positions.

As described above, acquisition section 72 executes a search process (S22) to search for the arrangement rule of the multiple mounting positions and then acquires the arrangement rule based on the result of the search process (S23). In this case, acquisition section 72 acquires the angle rule of the components at the multiple mounting positions based on the result of the angle rule search process (S222). In the search process (S222) for the angle rule, an angle rule which mounts components while rotating the components by a designated angle (e.g., 90 degrees) is detected. Also, if all mounting angles are identical, an angle rule in which mounting takes place without any rotation is detected.

Next, acquisition section 72 links the arrangement rule acquired in S23, the reference position, which is one of the multiple mounting positions related to the arrangement rule, with the region of substrate 80 (S24). When multiple arrangement rules are detected in S22 and S23, acquisition section 72 links a reference position and an arrangement rule to each of the multiple regions of substrate 80. When the arrangement rule search process (S22) has not been executed for all the component types in product information F2 (S25: NO), acquisition section 72 repeats S21 to S24.

When the arrangement rule search process (S22) has been executed for all the component types (S25: Yes), acquisition section 72 terminates the rule acquisition process. With the rule acquisition process (second mode) as described above, the reference position and the arrangement rule can be automatically acquired based on product information F2. This makes it possible to omit the inputting work by the operator and reduce the work load. In addition, with the search process (S22) as described above, it is possible to obtain an efficient arrangement rule corresponding to mounting positions arranged in a matrix.

Next, as shown in Fig. 5, data generation section 73 generates work data M1 for designating multiple mounting positions using the reference positions and the arrangement rules acquired by the rule acquisition process (S11) (S12). Next, work order setting section 74 sets the mounting order based on work data M1 generated in S12 and work condition Cd set in advance and generates order data M2 (S13). Work order setting section 74 performs a process of changing the mounting order (S14).

In the replacement process of the mounting order, as for whether work order setting section 74 replaces the mounting order based on the moving distance of mounting head 33 or the predetermined time required for the work, this is determined by the setting by the operator, for example. Work order setting section 74 edits order data M2 based on the result of the replacement process (S15). Work assistance device 70 generates work data M1 and order data M2 by the various processes as described above and ends the work assistance process.

Among the multiple mounting positions designated by input information F1 and product information F2, the mounting position and the component type are designated in work data M1, for example, similarly to a conventional control program. Work data M1 and order data M2 are sent from host computer 60 to target component mounting machine 3. Thereafter, work data M1 and order data M2 are developed by mounting position recognition section 51 and are used by mounting control section 52 for moving mounting head 33.

### 7. Effects of the configuration of the embodiment

Work assistance device 70 of the embodiment is applied to component mounting machine 3 for performing a predetermined operation at multiple work positions arranged in advance on substrate 80. Work assistance device 70 includes acquisition section 72 for acquiring the reference position and the arrangement rule of multiple work positions, and data generation section 73 for generating work data M1 that designates multiple work positions using the reference position and the arrangement rule acquired by acquisition section 72.

With such a configuration, even if a large number of work positions are arranged in advance on substrate 80, if these work positions have a predetermined arrangement rule, it is possible to generate work data M1 designating multiple work positions using a reference position and the arrangement rule. As a result, the file size of work data M1 can be reduced compared with control programs in which work positions are designated individually. Therefore, it is possible to reduce the time required for various processes on work data M1 including browsing and communicating. As a result, the production efficiency is improved.

Further, component mounting machine 3 of the embodiment includes mounting head 33 which is provided inside component mounting machine 3 in a manner which allows movement in the horizontal direction, mounting position recognition section 51 for recognizing multiple work positions by developing work data M1 which designates multiple mounting positions arranged in advance on substrate 80 using a reference position on substrate 80 and a predetermined arrangement rule, and mounting control section 52 for performing a predetermined operation by sequentially moving mounting head 33 to each of the recognized multiple work positions.

With such a configuration, it is possible to develop work data M1 in which the file size is reduced, compared with a control program that designates all work position individually, and perform a predetermined operation at multiple work positions. Thus, it is possible to reduce the time required for various processes including browsing and communicating work data M1. As a result, the production efficiency is improved. Further, increases in equipment costs can be suppressed as device configurations for handling large file sizes becomes unnecessary.

### 8. Modifications of the embodiment

### 8-1. Rule acquisition process by acquisition section 72

In the embodiment, the reference positions of the multiple mounting positions are arbitrarily set when obtaining the arrangement rule from product information F2 in addition to input information F1 inputted by an operator. When acquisition section 72 as described above arbitrarily sets a reference position, for example, the reference position is set to a mounting position at the start or end of the arrangement rule among multiple mounting positions arranged in a matrix.

The above-mentioned setting is made because the distance from the reference position to the first mounting position is eliminated by matching the start or the end of the arrangement rule with the first mounting position in the mounting order, thereby simplifying the designation of the multiple mounting positions in work data M1. Aside from the above-mentioned reference position, the reference position may be another mounting position except for the start and the end of the arrangement rule, or may be a position other than a mounting position. For example, acquisition section 72 may set the corner portion of substrate 80 or the origin of the coordinate system of substrate 80 as the reference position.

### 8-2. Configuration of work assistance device

**In** the embodiment, work assistance device 70 is configured to be incorporated into host computer 60. **In** contrast to this, work assistance device 70 may adopt various modes aside from constituting one function of host computer 60. For example, work assistance device 70 may be a dedicated external device connected in communication with production line L or host computer 60. At this juncture, work assistance device 70 may be connected to the substrate work machine via the internet. Regardless of the configuration, the same effect as the embodiment will be achieved.

### 8-3. Other

In the embodiment, with component mounting machine 3, which is a substrate work machine, as a target, work assistance device 70 is configured to assist in the mounting of a component by component mounting machine 3. In contrast, work assistance device 70 may assist a process other than the mounting process of component mounting machine 3. Here, component mounting machine 3 images a substrate with substrate camera 42 while a component is mounted, and based on the image data acquired by the imaging, whether the state of the mounted component is normal may be determined.

Note that the camera field of view of substrate camera 42 may be smaller than the imaging range of the substrate due to circumstances such as when a necessary resolution is being obtained. In such a case, component mounting machine 3 sequentially moves substrate camera 42 to each of multiple imaging positions by moving moving table 32. In such an imaging process, a control program in which the imaging positions are set as work positions is used. The multiple imaging positions may be arranged on the substrate in advance with a predetermined arrangement rule.

In the case as described above, work assistance device 70 acquires a reference position and an arrangement rule for the multiple imaging positions and generates work data based on the reference position and the arrangement rule. As a result, the same effect as in the embodiment can be obtained. Further, work assistance device 70 may target a substrate work machine other than component mounting machine 3 (e.g., various inspection devices, adhesive coating devices, chip transfer devices, and the like). For example, in the above-mentioned substrate work machine, the moving head is moved in a horizontal direction inside the substrate work machine, and a predetermined operation (imaging for inspection, adhesive coating, picking up and placing of chips, and the like) is performed at multiple work positions arranged on the substrate in advance with a predetermined arrangement rule.

In the case described above, work assistance device 70 acquires a reference position and an arrangement rule for the multiple work positions and generates work data based on the reference position and the arrangement rule. Further, the substrate work machine includes a work position recognition section for recognizing multiple work positions by developing work data and a work control section for performing a predetermined operation by sequentially moving the moving head to each of multiple recognized work positions. As a result, the same effect as in the embodiment can be obtained.

In the embodiment, work assistance device 70 transmits work data M1 and order data M2 to component mounting machine 3. Component mounting machine 3 is configured to develop the inputted work data M1 to recognize multiple mounting positions and recognizes the mounting order based on order data M2. On the other hand, work assistance device 70 may send developed data obtained by developing work data and order data to the substrate work machine.

With such a configuration, the file size of work data M1 stored in work assistance device 70 can be reduced. Further, it is possible to shorten the time required for various processes including browsing and communicating work data in work assistance device 70. Further, it is possible to handle a substrate work machine that does not have a work position recognition section.

### Reference Signs List

1: Production system, 2: Printing machine, 3: Component mounting machine (substrate work machine), 4: Reflow furnace, 5: Inspection machine, 30: Component transfer device, 33: Mounting head (moving head), 50: Control device, 51: Mounting position recognition section (work position recognition section), 52: Mounting control section (work control section), 70: Work assistance device, 71: Storage section, 72: Acquisition section, 73: Data generation section, 74: Work order setting section, F1: Input information, F2: Product information, Cd: Work condition, M1: Work data, M2: Order data, 80: Substrate, 81: First substrate, 82: Second substrate, 83: Third substrate, 91: First component, 92: Second component

## Claims

1. A work assistance device (70) for a substrate work machine (3), the substrate work machine configured to perform a predetermined operation at multiple work positions by moving a moving head (33) to each of the multiple work positions arranged in advance on a substrate (80), the work assistance device comprising:
an acquisition section (72) configured to acquire a reference position and an arrangement rule for multiple work positions, wherein the acquisition section is configured to execute a search process (S22) on design product information (F2), to search for the arrangement rule of multiple work positions and to acquire the arrangement rule based on the result of the search process, wherein, in the search process, the acquisition section is configured to search (S221) for the arrangement rule based on the spacing and quantity of the multiple work positions in each of a first direction and a second direction, both of which being horizontal directions orthogonal to each other, and
a data generation section (73) configured to generate work data (M1) for designating the multiple work positions using the reference position and the arrangement rule acquired by the acquisition section.

2. The work assistance device of claim 1, wherein the acquisition section (72) is configured to carry out an acquisition process in which the acquisition section is configured to acquire a reference position and an arrangement rule, in a first and a second mode, respectively, wherein in the first mode the acquisition process is configured to acquire the reference position and the arrangement rule for multiple work positions based on input information (F1) inputted by an operator, and wherein in the second mode the acquisition process is configured to execute the search process on design product information (F2) as defined in claim 1.

3. The work assistance device of any one of claims 1 or 2, wherein the reference position is any one of the multiple work positions.

4. The work assistance device of any one of claims 1 to 3, wherein the acquisition section is configured to acquire the arrangement rule of multiple work positions for each of the multiple regions when the arrangement rule is different for each of the multiple regions that do not overlap each other on the substrate; and
the data generation section is configured to generate the work data using the reference position and the multiple arrangement rules defined for each of the multiple regions when the acquisition section acquires multiple arrangement rules.

5. The work assistance device of any one of claims 1 to 4, wherein the substrate work machine is a component mounting machine configured to mount components at multiple mounting positions, the multiple mounting positions serving as multiple work positions.

6. The work assistance device of claim 5, wherein the acquisition section is configured to acquire an angle rule of the component at the multiple mounting positions when mounting is performed by the component mounting machine while systematically changing the angle of the component at each of the multiple mounting positions.

7. The work assistance device of any one of claims 1 to 6, wherein the work assistance device further comprises:
a work order setting section (74) configured to set a work order in which the substrate work machine performs the work at the multiple work positions designated by the work data (M1) based on a predetermined work condition (Cd), wherein the work condition includes at least one of a moving direction of the moving head (33), and the number of mountings in the same moving direction as that of the moving head.

8. The work assistance device of one of claims 1 to 7, wherein
the work order setting section (74) is configured to perform a replacement process (S15) of the work order that is set based on the work condition and the work data, the replacement being performed based on at least one of a moving distance of the moving head and the time required for the predetermined work, the replacement being determined by a setting by an operator.

9. A system comprising the substrate work machine and the work assistance device of any one of claims 1 to 8, wherein the substrate work machine comprises:
the moving head provided in a manner which allows movement in a horizontal direction inside the substrate work machine;
a work position recognition section (51) configured to recognize the multiple work positions by developing the work data designating the multiple work positions arranged in advance on the substrate using the reference position of the substrate and the predetermined arrangement rule; and
a work control section (52) configured to perform the predetermined work by sequentially moving the moving head to each of the multiple recognized work positions.

## Patentansprüche

1. Eine Arbeitsassistenzvorrichtung (70) für eine Substrat-Arbeitsmaschine (3), wobei die Substrat-Arbeitsmaschine so konfiguriert ist, dass sie einen vorbestimmten Vorgang an mehreren Arbeitspositionen ausführt, indem sie einen beweglichen Kopf (33) zu jeder der mehreren Arbeitspositionen bewegt, die zuvor auf einem Substrat (80) angeordnet wurden, wobei die Arbeitsassistenzvorrichtung aufweist:
einen Erfassungsabschnitt (72), der so konfiguriert ist, dass er eine Referenzposition und eine Anordnungsregel für mehrere Arbeitspositionen erfasst, wobei der Erfassungsabschnitt so konfiguriert ist, dass er einen Suchprozess (S22) für Konstruktionsproduktinformationen (F2) ausführt, um die Anordnungsregel für mehrere Arbeitspositionen zu suchen und die Anordnungsregel basierend auf dem Ergebnis des Suchprozesses zu erfassen, wobei in dem Suchprozess der Erfassungsabschnitt so konfiguriert ist, dass er (S221) die Anordnungsregel auf der Grundlage des Abstands und der Anzahl der mehreren Arbeitspositionen in jeder einer ersten Richtung und einer zweiten Richtung, die beide zueinander orthogonale horizontale Richtungen sind, sucht, und
ein Datenerzeugungsabschnitt (73) so konfiguriert ist, dass er Arbeitsdaten (M1) zum Bezeichnen der mehreren Arbeitspositionen unter Verwendung der Referenzposition und der Anordnungsregel erzeugt, die durch den Erfassungsabschnitt erfasst wurden.

2. Die Arbeitsassistenzvorrichtung nach Anspruch 1, wobei der Erfassungsabschnitt (72) so konfiguriert ist, dass er einen Erfassungsprozess durchführt, bei dem der Erfassungsabschnitt so konfiguriert ist, dass er eine Referenzposition und eine Anordnungsregel in einem ersten bzw. einem zweiten Modus erfasst, wobei im ersten Modus der Erfassungsprozess so konfiguriert ist, dass er die Referenzposition und die Anordnungsregel für mehrere Arbeitspositionen auf der Grundlage von Eingabeinformationen (F1) erfasst, die von einem Bediener eingegeben werden, und wobei in dem zweiten Modus der Erfassungsprozess so konfiguriert ist, dass er den Suchprozess für die in Anspruch 1 definierten Konstruktionsproduktinformationen (F2) ausführt.

3. Die Arbeitsassistenzvorrichtung nach einem der Ansprüche 1 oder 2, wobei die Referenzposition eine der mehreren Arbeitspositionen ist.

4. Die Arbeitsassistenzvorrichtung nach einem der Ansprüche 1 bis 3, wobei der Erfassungsabschnitt so konfiguriert ist, dass er die Anordnungsregel für mehrere Arbeitspositionen für jeden der mehreren Bereiche erfasst, wenn die Anordnungsregel für jeden der mehreren Bereiche, die sich auf dem Substrat nicht überlappen, unterschiedlich ist; und
der Datenerzeugungsabschnitt so konfiguriert ist, dass er die Arbeitsdaten unter Verwendung der Referenzposition und der mehreren Anordnungsregeln erzeugt, die für jeden der mehreren Bereiche definiert sind, wenn der Erfassungsabschnitt mehrere Anordnungsregeln erfasst.

5. Die Arbeitsassistenzvorrichtung nach einem der Ansprüche 1 bis 4, wobei die Substrat-Arbeitsmaschine eine Komponenten-Montagemaschine ist, die so konfiguriert ist, dass sie Bauteile an mehreren Montagepositionen montiert, wobei die mehreren Montagepositionen als mehrere Arbeitspositionen dienen.

6. Die Arbeitsassistenzvorrichtung nach Anspruch 5, wobei der Erfassungsabschnitt so konfiguriert ist, dass er eine Winkelregel des Bauteils an den mehreren Montagepositionen erfasst, wenn die Montage durch die Bauteil-Montagemaschine durchgeführt wird, während der Winkel des Bauteils an jeder der mehreren Montagepositionen systematisch geändert wird.

7. Die Arbeitsassistenzvorrichtung nach einem der Ansprüche 1 bis 6, wobei die Arbeitsassistenzvorrichtung ferner aufweist:
eine Arbeitsauftrag-Einstellsektion (74), die so konfiguriert ist, dass sie einen Arbeitsauftrag einstellt, bei dem die Substrat-Arbeitsmaschine die Arbeit an den mehreren Arbeitspositionen ausführt, die durch die Arbeitsdaten (M1) auf der Grundlage einer vorbestimmten Arbeitsbedingung (Cd) bestimmt sind, wobei die Arbeitsbedingung mindestens eine der folgenden Eigenschaften aufweist: eine Bewegungsrichtung des beweglichen Kopfes (33) und die Anzahl der Montagen in derselben Bewegungsrichtung wie die des beweglichen Kopfes.

8. Die Arbeitsassistenzvorrichtung nach einem der Ansprüche 1 bis 7, wobei
die Arbeitsauftrag-Einstellsektion (74) so konfiguriert ist, dass sie einen Ersetzungsprozess (S15) des Arbeitsauftrags durchführt, der auf der Grundlage der Arbeitsbedingung und der Arbeitsdaten eingestellt ist, wobei die Ersetzung auf der Grundlage mindestens einer der folgenden Größen durchgeführt wird: einer Bewegungsdistanz des Bewegungskopfes und der für die vorbestimmte Arbeit erforderlichen Zeit, wobei die Ersetzung durch eine Einstellung durch einen Bediener bestimmt wird.

9. Ein System, das die Substrat-Arbeitsmaschine und die Arbeitsassistenzvorrichtung nach einem der Ansprüche 1 bis 8 aufweist, wobei die Substrat-Arbeitsmaschine aufweist:
den beweglichen Kopf, der so vorgesehen ist, dass er sich in einer horizontalen Richtung innerhalb der Substrat-Arbeitsmaschine bewegen kann;
einen Arbeitspositionserkennungsabschnitt (51), der so konfiguriert ist, dass er die mehreren Arbeitspositionen erkennt, indem er die Arbeitsdaten, die die mehreren Arbeitspositionen bezeichnen, die zuvor auf dem Substrat angeordnet wurden, unter Verwendung der Referenzposition des Substrats und der vorbestimmten Anordnungsregel entwickelt; und
einen Arbeitssteuerungsabschnitt (52), der so konfiguriert ist, dass er die vorbestimmte Arbeit ausführt, indem er den beweglichen Kopf sequenziell zu jeder der mehreren erkannten Arbeitspositionen bewegt.

## Revendications

1. Dispositif d'assistance au travail (70) pour une machine de travail sur substrat (3), la machine de travail sur substrat configurée pour effectuer une opération prédéterminée à plusieurs positions de travail en déplaçant une tête de déplacement (33) vers chacune des plusieurs positions de travail agencées à l'avance sur un substrat (80), le dispositif d'assistance au travail comprenant :
une section d'acquisition (72) configurée pour acquérir une position de référence et une règle d'agencement pour plusieurs positions de travail, dans lequel la section d'acquisition est configurée pour exécuter un processus de recherche (S22) sur des informations de produit de conception (F2), pour rechercher la règle d'agencement de plusieurs positions de travail et pour acquérir la règle d'agencement sur la base du résultat du processus de recherche, dans lequel, dans le processus de recherche, la section d'acquisition est configurée pour rechercher (S221) la règle d'agencement sur la base de l'espacement et de la quantité des plusieurs positions de travail dans chacune d'une première direction et d'une deuxième direction, qui sont toutes deux des directions horizontales orthogonales l'une par rapport à l'autre, et
une section de génération de données (73) configurée pour générer des données de travail (M1) pour désigner les plusieurs positions de travail en utilisant la position de référence et la règle d'agencement acquises par la section d'acquisition.

2. Dispositif d'assistance au travail selon la revendication 1, dans lequel la section d'acquisition (72) est configurée pour exécuter un processus d'acquisition dans lequel la section d'acquisition est configurée pour acquérir une position de référence et une règle d'agencement, dans un premier et un deuxième mode, respectivement, dans lequel dans le premier mode le processus d'acquisition est configuré pour acquérir la position de référence et la règle d'agencement pour plusieurs positions de travail sur la base d'informations d'entrée (F1) entrées par un opérateur, et dans lequel dans le deuxième mode le processus d'acquisition est configuré pour exécuter le processus de recherche sur des informations de produit de conception (F2) telles que définies selon la revendication 1.

3. Dispositif d'assistance au travail selon l'une quelconque des revendications 1 ou 2, dans lequel la position de référence est l'une quelconque des plusieurs positions de travail.

4. Dispositif d'assistance au travail selon l'une quelconque des revendications 1 à 3, dans lequel la section d'acquisition est configurée pour acquérir la règle d'agencement des plusieurs positions de travail pour chacune des plusieurs régions lorsque la règle d'agencement est différente pour chacune des plusieurs régions qui ne se chevauchent pas sur le substrat ; et
la section de génération de données est configurée pour générer les données de travail en utilisant la position de référence et les plusieurs règles d'agencement définies pour chacune des plusieurs régions lorsque la section d'acquisition acquiert plusieurs règles d'agencement.

5. Dispositif d'assistance au travail selon l'une quelconque des revendications 1 à 4, dans lequel la machine de travail sur substrat est une machine de montage de composants configurée pour monter des composants à plusieurs positions de montage, les plusieurs positions de montage servant de plusieurs positions de travail.

6. Dispositif d'assistance au travail selon la revendication 5, dans lequel la section d'acquisition est configurée pour acquérir une règle d'angle du composant aux plusieurs positions de montage lorsque le montage est effectué par la machine de montage de composants tout en changeant systématiquement l'angle du composant à chacune des plusieurs positions de montage.

7. Dispositif d'assistance au travail selon l'une quelconque des revendications 1 à 6, dans lequel le dispositif d'assistance au travail comprend en outre :
une section de définition d'ordre de travail (74) configurée pour définir un ordre de travail dans lequel la machine de travail sur substrat effectue le travail aux plusieurs positions de travail désignées par les données de travail (M1) sur la base d'une condition de travail prédéterminée (Cd), dans lequel la condition de travail inclut au moins l'un des éléments suivants : une direction de déplacement de la tête de déplacement (33), et le nombre de montages dans la même direction de déplacement que celle de la tête de déplacement.

8. Dispositif d'assistance au travail selon l'une quelconque des revendications 1 à 7, dans lequel
la section de définition d'ordre de travail (74) est configurée pour effectuer un processus de remplacement (S15) de l'ordre de travail qui est défini sur la base de la condition de travail et des données de travail, le remplacement étant effectué sur la base d'au moins un parmi une distance de déplacement de la tête de déplacement et le temps requis pour le travail prédéterminé, le remplacement étant déterminé par un réglage effectué par un opérateur.

9. Système comprenant la machine de travail sur substrat et le dispositif d'assistance au travail selon l'une quelconque des revendications 1 à 8, dans lequel la machine de travail sur substrat comprend :
la tête de déplacement prévue de manière à permettre un déplacement dans une direction horizontale à l'intérieur de la machine de travail sur substrat ;
une section de reconnaissance de position de travail (51) configurée pour reconnaître les plusieurs positions de travail en développant les données de travail désignant les plusieurs positions de travail disposées à l'avance sur le substrat en utilisant la position de référence du substrat et la règle d'agencement prédéterminée ; et
une section de commande de travail (52) configurée pour effectuer le travail prédéterminé en déplaçant séquentiellement la tête de déplacement vers chacune des plusieurs positions de travail reconnues.
